# EUROPÄISCHE PATENTSCHRIFT

(11) **EP 4 161 793 B1**
(45) Veröffentlichungstag und Bekanntmachung des Hinweises auf die Patenterteilung: **07.10.2026**
(21) Anmeldenummer: 21730839.4
(22) Anmeldetag: 31.05.2021
(51) Int. Cl.: B60L 3/00, B60L 58/20

(54) **VERFAHREN ZUM ERFASSEN EINES ISOLATIONSFEHLERS IN EINEM FAHRZEUGBORDNETZ**
METHOD FOR DETECTING AN INSULATION FAULT IN A VEHICLE ON-BOARD ELECTRICAL SYSTEM
PROCÉDÉ POUR DÉTECTER UN DÉFAUT D'ISOLEMENT DANS UN RÉSEAU DE BORD DE VÉHICULE

(30) Priorität: 03.06.2020 DE 102020206953
(43) Veröffentlichungstag der Anmeldung: 12.04.2023
(73) Patentinhaber: Schaeffler Technologies AG & Co. KG, 91074 Herzogenaurach (DE)
(72) Erfinder: PFEILSCHIFTER, Franz, 81737 München (DE)
(74) Vertreter: Schaeffler Technologies
(86) Internationale Anmeldenummer: PCT/EP2021/064582
(87) Internationale Veröffentlichungsnummer: WO 2021/245037

(56) Entgegenhaltungen:
- EP-A1- 3 561 982
- WO-A1-2020/029901
- DE-A1- 10 247 282
- DE-A1- 102015 008 831
- DE-B3- 102018 217 116
- US-A1- 2009 015 973
- US-A1- 2013 300 430

## Beschreibung

Verfahren zum Erfassen eines Isolationsfehlers in einem Fahrzeugbordnetz Es ist bekannt, Fahrzeuge mit einem elektrischen Antrieb oder anderen elektrischen Komponenten auszustatten. Um hohe Leistungen zu erreichen, insbesondere zur Traktion, werden hohe Spannungen verwendet, beispielsweise von 400 Volt oder mehr, die im Gegensatz zu den ansonsten üblichen 12 Volt Bordnetzen eine Gefahr für den Menschen darstellen können.

Aus diesem Grund werden Fahrzeuge, die ein Bordnetz mit hoher Spannung aufweisen (d.h. ein Hochvoltbordnetz - HV-Bordnetz), mit einer Isolation versehen, welche das HV-Bordnetz von dem restlichen Bordnetz und dem Massepotential, insbesondere vom Chassis des Fahrzeugs, elektrisch trennt.

Da ein Fehler in der Isolation zu einer Berührspannung führen kann, die für den Menschen schädlich, wenn nicht tödlich ist, werden weitere Mechanismen zur Überwachung dieser Isolation vorgesehen. Eine derartige Isolationsüberwachung erfasst die beiden HV-Potentiale des HV-Netzes gegenüber Masse, um so Isolationswiderstände gegenüber Masse (Chassis) zu ermitteln. Besteht jedoch ein hochohmiger Isolationsfehler, so kann ein Teil des Niedervoltbordnetzes unerkannt mit einem gefährlichen HV-Potential verbunden sein. US 2013/300430 A1 offenbart Verfahren zum Erfassen eines Isolationsfehlers in einem Fahrzeugbordnetz mit einem HV-Bordnetzzweig und einem LV-Bordnetzzweig, wobei der LV-Bordnetzzweig ein positives Versorgungspotential und ein negatives Versorgungspotential aufweist, das einem Massepotential des Fahrzeugbordnetzes entspricht und der HV-Bordnetzzweig ein positives HV-Potential und ein negatives HV-Potential aufweist, die galvanisch von den Potentialen des LV-Bordnetzzweigs getrennt sind, wobei ein Isolationsfehler zwischen mindestens einem der HV-Potentiale und einem positiven LV-Potential erfasst wird.

DE 102 472 82 A1 offenbart ein Verfahren zum Kurzschluss-Schutz in einem Kraftfahrzeugstromnetz, das ein Zweispannungsstromnetz umfasst, wobei das Vorliegen eines zwischen einem Hochspannungsleiter und einem Niederspannungsleiter auftretenden Kurzschlusses erfasst wird, anschließend der DC/DC-Umformer abgeschaltet wird, die Massen der Niederspannungs- und Hochspannungsstromnetze getrennt werden.

Es ist eine Aufgabe der Erfindung, eine Möglichkeit aufzuzeigen, mit der sich ein Isolationsfehler zwischen einem HV-Bordnetzzweig und einem Niedervoltbordnetzzweig (LV-Bordnetzzweig) erfassen lässt, insbesondere auch wenn der Isolationsfehler hochohmig ist.

Diese Aufgabe wird gelöst, durch das Verfahren durch Anspruch 1. Weitere Merkmale, Ausführungsformen, Eigenschaften und Vorteile ergeben sich mit den abhängigen Ansprüchen sowie mit der Figur und der Beschreibung.

Es wird vorgeschlagen, eine Spannungsbegrenzungsschaltung im LV-Bordnetzzweig (entsprechend einem Niedervoltbordnetzzweig) vorzusehen, so dass ein Stromfluss durch diese Schaltung anzeigt, dass ein HV-Potential mit einem Versorgungspotential des LV-Bordnetzzweigs verbunden ist. Beispielsweise eine Kommunikations-, Steuer- oder Sensorkomponente innerhalb des LV-Bordnetzzweigs kann durch einen Isolationsfehler mit einem HV-Potential in Kontakt kommen. Jedoch kann abhängig von der Komponente diese ohne merklichen oder ohne überwachten Stromfluss durchbrennen, so dass das LV-Potential zwar aufgrund der durchgebrannten Komponente nicht mit dem Rest LV-Bordnetzzweig in Berührung kommt, jedoch eine Leitung oder eine andere Komponente des LV-Bordnetzes das HV-Potential führt. Durch die Spannungsbegrenzungsschaltung wird somit ein dezidiertes und verlässliches Element geschaffen, das einen erfassbaren und verlässlichen Stromfluss hervorruft, wenn durch Isolationsfehler ein HV-Potential mit dem Potential des LV-Bordnetzzweigs in Kontakt kommt. Wenn beispielsweise eine Leitung eines Niedervolt-Sensorgeräts (oder eines anderen LV-Geräts), der an den LV-Bordnetzzweig angeschlossen ist, durch einen Isolationsfehler mit einem HV-Potential in Kontakt kommt, so kann etwa eine Eingangsstufe (allgemeiner: Daten- oder Meßschnittstelle) des Sensorgeräts, an die die Sensorleitung angeschlossen ist, unbemerkt durchbrennen, so dass kein Stromfluss zwischen dem HV-Bordnetzzweig und dem LV-Bordnetzzweig besteht. Jedoch verbleibt die Sensorleitung am HV-Potential aufgrund des Isolationsfehlers und es besteht auch kein erfassbarer Stromfluss aufgrund der durchgebrannten Eingangsstufe. Über diese Sensorleitung könnte dann ein HV-Potential an weitere Komponenten gelangen, insbesondere da das Sensorgerät und dessen Leitung nicht für Hochvolt-Anwendungen ausgelegt ist und somit auch keine entsprechende Isolation aufweist. Ähnliches gilt für Kommunikations- oder Steuergeräte des LV-Bordnetzzweigs und deren Schnittstelle.

Mit dem hier vorgeschlagenen Verfahren lässt sich mittels der Spannungsbegrenzungsschaltung gezielt ein Stromfluss erzeugen, der nicht von dem Durchbrennverhalten beispielsweise einer (Daten-)Schnittstelle eines Sensorgeräts, einer Schnittstelle eines Kommunikationsgeräts oder eines Steuergeräts abhängt oder von anderen Elementen des LV-Bordnetzzweigs, wenn ein HV-Potential an dieses gelangt. Durch die Spannungsbegrenzungsschaltung lässt sich erfassbar und sicher ein Stromfluss erkennen, der darauf hinweist, dass ein HV-Potential an einer Komponente des LV-Bordnetzzweigs angelegt ist.

Insbesondere lässt sich die Spannungsbegrenzungsschaltung auf einfache Weise an die Spannung des HV-Bordnetzes anpassen, wobei dies für LV-Komponenten nicht der Fall ist. Eine derartige Anpassung wäre beispielsweise eine Ausführung, bei der ein definierter Stromfluss durch die Spannungsbegrenzungsschaltung führt, wenn an dieser eine HV-Spannung (Spannung zwischen HV+ und HV- oder zwischen Masse und HV+ oder HV-) anliegt. Mit der hier beschriebenen Vorgehensweise lässt sich insbesondere erkennen, wenn ein HV-Potential an einer Komponente des LV-Bordnetzzweigs (etwa eine Steuer- Kommunikations- oder Sensorkomponente) anliegt, auch wenn kein erfassbarer Strom aufgrund des Isolationsfehlers fließt. Beispielsweise eine aktive Messung des Isolationswiderstands würde einen derartigen Sensorfehler nicht verlässlich erfassen, insbesondere wenn durch Durchbrennen eines Bauteils in der LV-Komponente die Verbindung zwischen der daran angeschlossenen Leitung (Niedervolt) und dem restlichen LV-Bordnetzzweig nicht gegeben ist. Die Begriffe LV-Komponente und LV-Gerät (etwa in Steuer- Kommunikations- oder Sensorgerät) sind hier Synonyme.

Es wird daher ein Verfahren zum Erfassen eines Isolationsfehlers in einem Fahrzeugbordnetz beschrieben. Das Fahrzeugbordnetz weist hierbei einen HV-Bordnetzzweig sowie einen LV-Bordnetzzweig auf. Der HV-Bordnetzzweig kann auch als Hochvolt-Bordnetzzweig bezeichnet werden. Der LV-Bordnetzzweig kann auch als Niedervolt-Bordnetzzweig bezeichnet werden. Die Vorsilbe "Hochvolt" bzw. "HV-" definiert Komponenten oder Bordnetzzweige oder Abschnitte hiervon, die mit Betriebsspannungen von mehr als 60 Volt, insbesondere mindestens 200, 400, 600, 800 oder 100 Volt arbeiten. Diese stellen eine Gefahr für den Menschen dar, falls dieser in Kontakt mit der Betriebsspannung kommt. Die Vorsilben "LV-" und "Niedervolt" sind synonym und bedeuten eine Betriebsspannung von weniger als 60 Volt, insbesondere von beispielsweise 12 bis14 Volt, davon im Wesentlichen 24 Volt oder im Wesentlichen 48 Volt. Diese Betriebsspannungen erfordern keine besonderen Maßnahmen, um einen Kontakt mit der betreffenden Betriebsspannung zu vermeiden.

Der LV-Bordnetzzweig hat ein positives Versorgungspotential und ein negatives Versorgungspotential. Das negative Versorgungspotential entspricht einem Massepotential des Fahrzeugbordnetzes, insbesondere dem Chassis-Potential. Der HV-Bordnetzzweig weist ein positives und ein negatives HV-Potential auf. Diese beiden HV-Potentiale sind galvanisch von den Potentialen des LV-Bordnetzzweigs getrennt. Diese galvanische Trennung basiert insbesondere auf einer (elektrischen) Isolation, wobei hier beschrieben wird, wie ein Fehler in dieser Isolation erfasst werden kann. Die HV-Potentiale haben keinen Bezug zum Massepotential um so einen gefährdeten Strom bei Berühren zu vermeiden.

Es wird ein Isolationsfehler zwischen mindestens der HV-Potentiale und einem positiven LV-Potential erfasst. Als positives LV-Potential wird hierbei ein gegenüber Masse positives LV-Potential als Versorgungspotential bezeichnet, sowie Potentiale, die nicht Masse sind, etwa Signalpotentiale wie Steuer-, Daten- oder Meßsignale, da diese üblicherweise gegenüber Masse positiv sind. Jedoch können diese auch gegenüber Masse zumindest zeitweise negativ sein, abhängig von der spezifischen Ausprägung des Bordnetzes und von dem übertragenen Signal.

Die HV-Potentiale Versorgungspotentiale. Das LV-Potential kann wie erwähnt ein positives LV-Versorgungspotential sein, kann jedoch auch ein Potential eines Leiters sein, beispielsweise eines Sensor-, Kommunikations- oder Steuerleiters oder einer anderen Komponente. Der Isolationsfehler wird erfasst durch Erkennen eines Stromflusses durch eine Spannungsbegrenzungsschaltung. Diese Spannungsbegrenzungsschaltung ist zwischen dem Massepotential und dem positiven LV-Potential (das heißt dem zu überwachenden Potential) angeschlossen. Die Spannungsbegrenzungsschaltung ist eingerichtet, unterhalb einer Durchbruchsspannung nicht zu leiten und oberhalb dieser Spannung zu leiten. Dadurch gibt der Stromfluss eine zu hohe Spannung an, d.h. eine Spannung oberhalb einer Durchbruchsspannung der Spannungsbegrenzungsschaltung.

Diese Durchbruchsspannung ist größer als die maximale Betriebsspannung bzw. Nennspannung des LV-Bordnetzzweigs, sodass ein Stromfluss nur dann zustande kommt, wenn das positive LV-Potential gegenüber Masse eine zu hohe Spannung aufweist. Eine zu hohe Spannung ist hierbei eine Spannung, die über der Durchbruchsspannung liegt, insbesondere die über einem vorgegebenen Wert oder über der Maximal-Betriebsspannung des LV-Bordnetzzweigs liegt. Da die Spannungsbegrenzungsschaltung mit spezifischen Merkmalen ausgestattet ist, nämlich einem Stromfluss oberhalb einer bestimmten Durchbruchsspannung, während beispielsweise Komponenten oder Geräte wie Sensorauswerteschaltungen, Kommunikationsschaltungen, Steuerschaltungen und Ähnliches nicht notwendigerweise diese Merkmale aufweisen, kann mittels der Spannungsbegrenzungsschaltung zuverlässig eine zu hohe Spannung an dem positiven LV-Potential erkannt werden, auch wenn ansonsten kein Strom vom HV-Bordnetzzweig zur Masse fließt, das heißt auch wenn durch aktive Isolationswiderstandsmessung der Fehler nicht eindeutig erkannt werden kann. Insbesondere die betreffenden Schnittstellen, über die eine Leitung an die betreffende Komponente angeschlossen ist, haben kein verlässliches Verhalten bei Überspannung, insbesondere da auch diese für eine Niederspannung (< 60 V) ausgelegt sind.

Eine Ausführungsform sieht vor, dass der Stromfluss erkannt wird anhand einer Verschiebung eines der HV-Potentiale gegenüber dem Massepotential. Dies wird ermittelt durch eine passive Spannungsmessung der HV-Potentiale gegenüber dem Massepotential. Hierbei kann auch nur ein HV-Potential gegenüber dem Massepotential gemessen werden. Insbesondere kann ein HV-Potential ermittelt werden durch Erfassen der Spannungen zwischen den HV-Potentialen und durch Subtraktion der Spannung zwischen den anderen HV-Potentialen und Massepotential.

Die Spannungsbegrenzungsschaltung erzeugt durch den Stromfluss gezielt eine Verschiebung zumindest eines der HV-Potentiale gegenüber Massepotential, wenn ein Isolationsfehler zwischen einem HV-Potential und einem positiven LV-Potential besteht. Ohne Spannungsbegrenzungsschaltung würde dies von der Eigenschaft der LV-Komponente abhängen, an der das positive LV-Potential vorgesehen ist, insbesondere davon, ob diese Komponente einen verlässlichen Stromfluss bei Überspannung am LV-Potential erzeugt, oder ob die Komponente durch Durchbrennen eines Bauteils (einer Schnittstelle einer LV-Komponente oder einer LV-Komponente selbst) oder einer Sicherung keinen entsprechenden Stromfluss bei zu hoher Spannung am LV-Potential erzeugt.

Der Stromfluss durch die Spannungsbegrenzungsschaltung kann ferner erkannt werden anhand einer Potentialveränderungsrate, die über einem vorbestimmten Wert liegt. Die Potentialveränderungsrate gibt an, wie sehr sich die Cy-Kapazitäten (parasitär oder dezidierte Filterkondensatoren) umladen, wenn der Stromfluss besteht. Der vorbestimmte Wert, anhand dessen der Stromfluss erkannt wird, liegt insbesondere über einem Wert, der die maximale Potentialveränderungsrate bei aktiver Isolationsmessung auftritt. Die Potentialveränderungsrate ist insbesondere die Rate, mit der sich die Spannung zwischen einem der HV-Potentiale gegenüber dem Massepotential über die Zeit ändert. Der vorbestimmte Wert kann hierbei mindestens 100 Volt/ms, 500 Volt/ms, 100 Volt/ms oder mindestens 100 Volt/µs betragen. Es wird kein Stromfluss gemäß dem hier vorgesehenen Verfahren erkannt, wenn die Potentialveränderungsrate unter dem vorbestimmten Wert liegt.

Alternativ oder in Kombination hierzu kann der Stromfluss erkannt werden durch die Höhe der Potentialdifferenz, die sich durch die Änderung ergibt, das heißt die Potentialdifferenz, die sich nach der Änderung ergibt. Dies entspricht dem stationären Fall der Potentialänderung, d.h. die Potentialdifferent nach der Potentialänderung. Der Stromfluss kann somit erkannt werden anhand einer Änderung auf eine Potentialdifferenz zwischen dem HV-Potential und dem Massepotential. Der Stromfluss wird dann erkannt, wenn die sich einstellende Potentialdifferenz unter einem vorbestimmten Wert liegt. Vorzugsweise wird diese Potentialdifferenz erfasst, während die Spannung zwischen den HV-Potentialen in einem Normbereich liegt. Der Normbereich entspricht hierbei beispielsweise der Norm-Betriebsspannung. Der vorbestimmte Wert kann hierbei beispielsweise maximal 60 Volt, 50 Volt, 30 Volt oder 20 Volt betragen, insbesondere maximal 20 Volt oder 16 Volt. In einer beispielhaften Ausführungsform beträgt der vorbestimmte Wert ca. 60 Volt, 50 Volt oder 40 Volt oder auch 20 V oder 16 V. Vorzugsweise liegt der vorbestimmte Wert unter dem Minimalwert, der bei einer aktiven Isolationsmessung auftritt.

Eine Ausführungsform sieht vor, dass die Verschiebung mittels eines Isolationswächters oder mittels mindestens eines Spannungsmessers erkannt wird, die einen Teil des Isolationswächters darstellen oder mit diesem verbunden sind.

Es kann vorgesehen sein, dass der Isolationswächter ferner einen aktiven Isolationstest des HV-Bordnetzzweigs ausführt. Dies wird ausgeführt, indem Cy-Kapazitäten zwischen Masse einerseits und den HV-Potentialen andererseits aktiv umgeladen bzw. entladen (oder geladen) werden. Die Cy-Kapazitäten können sich aus parasitären Kapazitäten und aus dedizierten Filtern zusammensetzen, wie sie beispielsweise in EMV-Filtern verwendet werden. Da die Höhe der Cy-Kapazitäten im Wesentlichen bekannt sind, ergibt sich anhand des ebenfalls bekannten Stroms der aktiven Umladung oder Entladen eine Potentialänderungsrate (zwischen Masse einerseits und mindestens einem HV-Potential anderseits), die kennzeichnend für den Isolationswiderstand ist. Der aktive Isolationstest ist somit ein Test der Entladung oder Aufladungsgeschwindigkeit der Cy-Kapazitäten bei anliegendem Teststrom. Der Teststrom wird vorzugsweise von einem Isolationswächter erzeugt oder zumindest gesteuert. Der aktive Isolationstest sieht ferner vor, dass eine Potentialverschiebung erfasst wird, die sich durch das Umladen ergibt. Dies betrifft eine Verschiebung eines HV-Potentials gegenüber Masse. Da der Isolationswächter die Potentialverschiebung der HV-Potentiale gegenüber dem Massepotential erfasst, kann dieser auch dazu dienen, einen Stromfluss durch die Spannungsbegrenzungsschaltung zu erkennen.

Ein weiterer Aspekt ist es, dass bei Erkennen eines Stromflusses durch die Spannungsbegrenzungsschaltung das aktive Umladen bzw. Entladen durch den Isolationswächter unterbrochen wird. Der Stromfluss kann hierbei insbesondere mittels einer Potentialverschiebung erkannt werden, die sich durch den Stromfluss durch die Spannungsbegrenzungsschaltung ergibt. Hierbei kann mindestens ein Spannungsmesser verwendet werden, der auch für den aktiven Isolationstest des Isolationswächters verwendet wird, oder es kann mindestens ein Spannungsmesser verwendet werden, der von dem Isolationswächter nicht ausgewertet wird.

Vorzugsweise sinkt während des aktiven Umladens eine Potentialdifferenz zwischen einem der HV-Potentiale und dem Massepotential nicht unter eine Minimalspannung. Dies gilt insbesondere für deren Beträge. Die Minimalspannung für einen HV-Bordnetzzweig mit einer Nominalspannung von 800 V beträgt beispielsweise mindestens 60 V oder 100 V. Die durch den aktiven Isolationstest hervorgerufene Minimalspannung beträgt mindestens 7%, 8%, 10% oder 15% der Nennspannung des HV-Bordnetzes. Der Stromfluss durch die Spannungsbegrenzungsschaltung wird vorzugsweise erkannt anhand einer Änderung auf eine Potentialdifferenz zwischen dem HV-Potential und dem Massepotential, die unter einem vorbestimmten Wert liegt. Dieser Wert ist insbesondere kleiner als die Minimalspannung. Bei einem HV-Bordnetzzweig mit einer Nominalspannung von 800 V beträgt dieser Wert beispielsweise maximal 15 Volt, 16 Volt, 20 Volt oder 25 Volt, ggf. auch 30 Volt oder 40 Volt oder 50 Volt (insbesondere weniger als 60 Volt). Das Intervall, aus dem die Minimalspannung gewählt ist, liegt über dem Intervall, aus dem der vorbestimmte Wert gewählt ist.

Mit anderen Worten wird daher von dem Isolationswächter bei der aktiven Isolationswiderstandsmessung zwar umgeladen (betreffend die Cy-Kondensatoren) und es kann sich die Minimalspannung ergeben, jedoch ergibt sich bei der aktiven Isolationsmessung kein Spannungswert, der für die Erfassung eines Stromflusses durch die Spannungsbegrenzungsschaltung relevant wäre (= vorbestimmter Wert). Bei einem Stromfluss durch die Spannungsbegrenzungsschaltung fließt vielmehr ein Strom, bei dem sich eine Potentialdifferenz einstellt, die (etwa um eine vorbestimmte Marge) kleiner ist als die Minimalspannung, die bei der üblichen aktiven Isolationswiderstandsmessung (kurz: Isolationsmessung) auftritt. Dadurch können die verschiedenen Messungen auseinandergehalten werden und es können auch unterschiedliche Fehlerarten ausgegeben werden, nämlich ein erster Fehler, wenn der Spannungswert unter dem vorbestimmten Wert liegt, und ein zweiter Fehler, wenn die Isolationswiderstandsmessung zu einem Widerstandswert führt, der unter einem Widerstandsgrenzwert liegt.

Es kann vorgesehen sein, dass der Stromfluss durch die Spannungsbegrenzungsschaltung erkannt wird durch Messen mindestens einer Spannung zwischen dem mindestens einen der HV-Potentiale einerseits und dem Massepotential andererseits. Hierbei wird mindestens ein Spannungsmesser verwendet, der mit dem Isolationsrichter verbunden ist oder Teil hiervon ist. Alternativ kann mindestens ein Spannungsmesser, der von einer eigenen Auswerteschaltung ausgewertet wird, verwendet wird. Dieser Spannungsmesser hat keine direkte signalübertragende Verbindung mit dem Isolationswächter. Mit anderen Worten kann vorgesehen sein, dass der hierbei verwendete Spannungsmesser nicht von dem Isolationswächter ausgewertet wird.

Wenn daher eine Potentialdifferenz ermittelt wird, die sich durch den Stromfluss durch die Spannungsbegrenzungsschaltung ergibt, kann dies ausgeführt werden von mindestens einem Spannungsmesser und einer damit verbundenen, eigenen Auswerteschaltung, die zumindest in logischer Hinsicht von dem Isolationswächter getrennt sind. Der betreffende Spannungsmesser und die Auswerteschaltung bilden hiermit eine autarke Einheit, die beispielsweise innerhalb eines Hochvoltgehäuses vorgesehen ist, in der auch weitere Komponenten des Hochvoltbordnetzzweigs vorhanden sind, beispielsweise HV-Schalter und/oder ein HV-Akkumulator, ggf. auch ein HV-Spannungswandler und/oder eine HV-Ladeschaltung.

Es kann mindestens eine der folgenden Maßnahmen durchgeführt werden, wenn der Isolationsfehler durch Erkennen eines Stromflusses durch die Spannungsbegrenzungsschaltung hindurch erkannt wird. Als Maßnahme kann vorgesehen sein, dass ein Hochvoltakkumulator des HV-Bordnetzzweigs mittels Trennschalter vom restlichen HV-Bordnetzzweig abgetrennt wird. Es kann ferner vorgesehen sein, dass mindestens ein Cy-Kondensator des HV-Bordnetzzweigs abgetrennt wird, insbesondere die Cy-Filterkondensatoren eines Inverters und/oder eines Traktionsmotors. Alternativ oder zusätzlich kann als Maßnahme vorgesehen sein, dass eine an das HV-Bordnetz angeschlossene Ladesäule abgetrennt wird. Zudem kann vorgesehen sein, dass als Maßnahme der HV-Bordnetzzweig entladen wird (insbesondere zu Massepotential hin). Schließlich kann als Maßnahme vorgesehen sein, dass ein HV-Bordnetzunterzweig von einem Inverter-HV-Bordnetzunterzweig abgetrennt wird. Hierbei weist der Inverter-HV-Bordnetzunterzweig den Traktionsinverter auf. Dies kann insbesondere vorgesehen werden, indem der Inverter-HV-Bordnetzunterzweig abgetrennt wird. Der Inverter-HV-Bordnetzunterzweig weist den Traktionsinverter auf und/oder eine elektrische Maschine, die zur Traktion des Fahrzeugs dient.

Wird beispielsweise bei erfasstem Isolationsfehler ein Cy-Filterkondensator abgetrennt, so ergibt sich zwar eine schlechtere EMV-Filtereigenschaft. Jedoch wird durch die Abtrennung vermieden, dass sich zu hohe Berührspannungen ergeben.

Es kann vorgesehen sein, dass die Spannungsbegrenzungsschaltung, deren Stromfluss erkannt wird, zwischen dem Massepotential und einem positiven LV-Potential angeschlossen ist, welches ein positives Versorgungspotential des LV-Bordnetzes führt (im Normalfall).

Ferner kann vorgesehen sein, dass die Spannungsbegrenzungsschaltung, deren Stromfluss erkannt wird, zwischen dem Massepotential und einem (positiven) LV-Potential angeschlossen ist, welches ein Leitungspotential des LV-Bordnetzes ist. Ein derartiges Leitungspotential kann ein Potential einer Sensorleitung oder einer Kommunikationsleitung oder einer Steuerleitung sein.

Es kann ein LV-Gerät an das Massepotential und an ein positives Versorgungspotential des LV-Bordnetzzweigs angeschlossen sein. Dieser Anschluss kann über eine erste Anschlussseite vorgesehen sein. Zudem kann, etwa an einer anderen Anschlussseite, etwa an einer Schnittstelle des LV-Geräts, mindestens eine Leitung angeschlossen sein, wobei diese Leitung ein (positives) LV-Potential aufweisen kann (bzw. ein Potential, das von Masse abweicht). An dieser Seite können mehrere Leitungen angeschlossen sein, wobei zumindest eine der Leitungen das von Masse abweichende, üblicherweise positive, LV-Potential aufweist. Beispielsweise kann dies eine Signalleitung sein. Die Spannungsbegrenzungsschaltung kann zwischen einem Massepotential und einem Leiter angeschlossen sein, der beispielsweise ein Leiter einer Sensorleitung oder einer Kommunikationsleitung ist. Die Leitung, an die die Spannungsbegrenzungsleitung angeschlossen ist, ist gemäß einer Ausführungsform nicht notwendigerweise ein positives LV-Potential im Sinne eines positiven Versorgungspotentials, sondern kann beispielsweise eine Signalleitung sein.

Das LV-Gerät kann eine LV-Kommunikationsvorrichtung etwa eine CAN-Bus-Schaltung oder eine LV-Sensorvorrichtung sein, beispielsweise eine Temperatur-, Strom- oder Spannungsmesseinheit. Ferner kann das LV-Gerät ein LV-Steuergerät sein. Hierbei kann die Leitung bzw. kann das LV-Potential, an das die Spannungsbegrenzungsschaltung angeschlossen ist, eine Steuerleitung sein oder ein Leiter, der Teil einer Steuerleitung ist.

Schließlich kann die Spannungsbegrenzungsschaltung, deren Stromfluss gemessen wird, einen Varistor, einen Gasableiter, eine Funkenstrecke, eine Schutzdiode, eine Tyristorschaltung, einen DIAC, eine Zener-Diode und/oder eine Vierschichtdiode aufweisen. Die Spannungsbegrenzungsschaltung ist eingerichtet, oberhalb einer Grenzspannung (= Durchbruchsspannung) zu leiten und unterhalb einer Grenzspannung nicht zu leiten. Daher gibt der Stromfluss eine überhöhte Spannung an, das heißt, eine Spannung, die über der Grenzspannung bzw. Durchbruchsspannung liegt. Die genannten Komponenten können auch in beliebiger Kombination der Spannungsbegrenzungsschaltung vorgesehen sein.

Die Spannungsbegrenzungsschaltung kann zwischen dem Massepotential und einem LV-Potential angeschlossen sein und kann über eine Sicherung mit dem Abschnitt des LV-Bordnetzzweigs verbunden sein, in dem sich ein Niedervoltakkumulator befindet. Dadurch kann bei fehlerhafter Isolation die Sicherung durchbrennen, während die Spannungsbegrenzungsschaltung weiterhin einen Stromfluss aufgrund des verringerten Isolationswiderstandes vorsieht, der erfasst werden kann und anhand dessen ein Fehler ausgegeben werden kann. Die Sicherung dient dann zum Schutz des LV-Geräts und insbesondere der Schnittstelle des LV-Geräts, die über die Sicherung angeschlossen ist.

Ferner kann ein Bordnetz vorgesehen sein, das zur Ausführung des Verfahrens ausgestaltet ist, insbesondere in dem das Bordnetz zum Erfassen eines Isolationsfehlers in dem Fahrzeugbordnetz ausgestaltet ist, einen HV-Bordnetzzweig und einen LV-Bordnetzzweig aufweist, der LV-Bordnetzzweig ein positives Versorgungspotential und ein negatives Versorgungspotential aufweist, wobei das einem Massepotential (M) des Fahrzeugbordnetzes entspricht und wobei der HV-Bordnetzzweig ein positives HV-Potential und ein negatives HV-Potential aufweist, die galvanisch von den Potentialen des LV-Bordnetzzweigs getrennt sind. Das Bordnetz ist ferner ausgestaltet einen Isolationsfehler zwischen mindestens einem der HV-Potentiale und einem positiven LV-Potential zu erfassen durch Erkennen eines Stromflusses durch eine Spannungsbegrenzungsschaltung, wobei das Bordnetz eine derartige Spannungsbegrenzungsschaltung aufweist, die zwischen dem Massepotential und dem positiven LV-Potential angeschlossen ist. Ferner kann das Bordnetz Vorrichtungsmerkmale aufweisen, die im Rahmen des hier beschriebenen Verfahrens genannt sind, und das Bordnetz kann eingerichtet sein, die hier beschriebenen Verfahrensmerkmale zu realisieren.

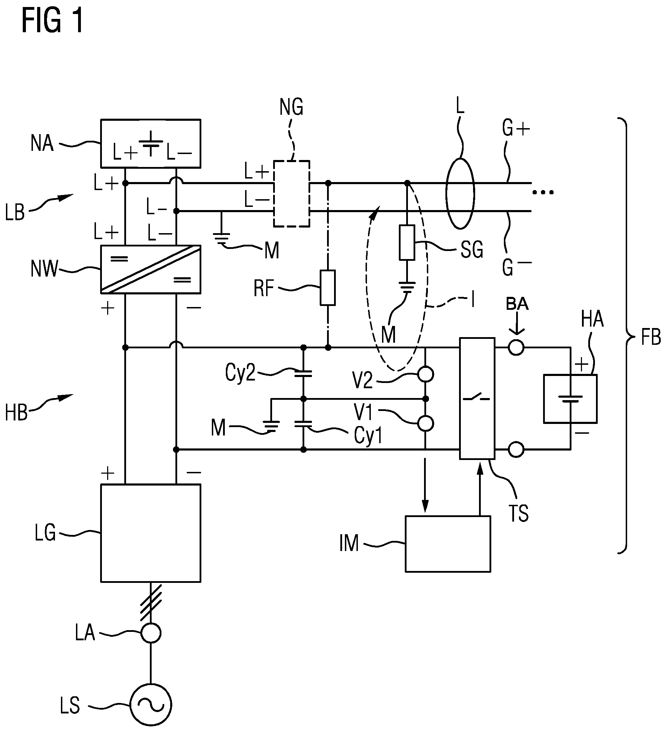

Die Figur 1 dient zur näheren Erläuterung des hier beschriebenen Verfahrens und zeigt eine zur Ausführung des Verfahrens vorgesehene Bordnetzschaltung.

Die Figur 1 zeigt ein Fahrzeugbordnetz FB mit einem Niedervoltakkumulator NA, der über einen Niedervolt-Wandler mit einem HV-Bordnetzzweig HB verbunden ist. Der HV-Bordnetzzweig LB ist über den Wandler NW mit dem LV-Bordnetzzweig LB verbunden, in dem sich auch der Niedervoltakkumulator NA befindet. In dem Hochvoltbordnetzzweig HB ist ein Hochvoltakkumulator HA vorgesehen, der über eine Trennvorrichtung TS sowie über einen Akkumulatoranschluss BA angeschlossen ist. Der Akkumulatoranschluss BA befindet sich zwischen dem Hochvoltakkumulator HA und den Trennschaltern TS. Die Trennschalter sind zweipolig ausgeführt.

In dem Hochvoltbordnetz HB befinden sich ferner Cy-Kondensatoren Cy1, Cy2. Diese befinden sich zwischen dem Massepotential M und dem negativen HV-Potential HV-, bzw. zwischen dem Massepotential M und dem positiven HV-Potential HV+. In dem Niedervoltbordnetzzweig LB ist ein negatives LV-Potential L- vorgesehen, dass dem Massepotential M entspricht. Das Massepotential M entspricht vorzugsweise wiederum dem Chassis-Potential des Fahrzeugs. Ein positives LV-Potential L, welches einem Versorgungspotential entspricht, ist ebenso vorgesehen.

Die beiden Versorgungspotentiale L-, L+ des HV-Bordnetzzweigs versorgen ein Niederspannungsgerät NG, beispielsweise eine Sensorauswerteschaltung. Die Sensorauswerteschaltung umfasst ferner eine Leitung L mit einem positiven LV-Potential G+ und einem negativen LV-Potential G-. Das Potential G- kann dem Potential L- bzw. M entsprechen. Das positive Potential G+ ist ein positives Leitungspotential, kann jedoch allgemein ein Leitungspotential sein, beispielsweise als Potential eines Signalleiters. Das Niederspannungsgerät NG kann auch als LV-Gerät bezeichnet werden.

Wie dargestellt, kann die Leitung L weitergeführt sein und zu weiteren Komponenten führen, beispielsweise zu weiteren Sensoren. Beispielsweise kann das Niederspannungsgerät NG eine Kommunikationsvorrichtung sein, beispielsweise ein CAN-Bus-Schaltung, an die sich mehrere weitere Komponenten anschließen. Insbesondere kann die Leitung aus einem Gehäuse herausführen, in dem sich HV-Komponenten befinden und kann insbesondere in einen Bereich hinausgeführt sein, in dem sich LV-Komponenten oder Leiter mit Massepotential befinden. Es wäre kritisch, wenn die Leitung HV-Potential führen würde, da diese in Kontakt mit Masse oder LV-Komponenten kommen kann, insbesondere da die Leitung für LV-Anwendungen ausgestattet ist und somit keine Isolation aufweist, wie sie für HV-Komponenten verwendet wird.

Um zu vermeiden, dass sich ein Isolationsfehler in das Potential G+, das heißt allgemein in ein Signalpotential des LV-Bordnetzzweigs LB fortsetzt, ist eine Spannungsbegrenzungsschaltung SG vorgesehen. Besteht ein Isolationsfehler in Form eines zugehörigen Widerstandes RF, vergleiche strichpunktierte Verbindung, dann ist über diesen fehlerhaften Isolationswiderstand das positive HV-Potential + mit dem Potential G+ verbunden und somit mit einem Leiter bzw. einer Leitung L, die dem LV-Bordnetzzweig angehört und zu weiteren Komponenten führen kann. Dadurch können auch weitere Komponenten des LV-Bordnetzes mit dem HV-Potential + belastet sein, dies führt zu möglicherweise gefährlichen Berührspannungen an weiteren LV-Komponenten.

Die Spannungsbegrenzungsschaltung SG dient dazu, einen Stromfluss I gezielt und vorhersehbar zu erzeugen, wenn über den Isolationsfehler RF ein HV-Potential (+) in das LV-Bordnetz LB übertritt. Der Stromfluss I ist mit gestrichelter Linie dargestellt. Zum einen kann die sich ergebende Potentialverschiebung zwischen Massepotential M und einen der HV-Potentiale +, - erfasst werden. Zum anderen kann der Stromfluss I auch von einem Strommesser erfasst werden. Vorzugsweise wird die Verschiebung erfasst, indem eine Änderungsrate betrachtet wird, die sich durch das plötzliche Auftreten des Isolationswiderstandes RF ergibt. Diese Änderungsrate ist deutlich schneller als die Änderungsrate des Potentials +, - gegenüber M, die durch den Teststrom bei einer aktiven Isolationsmessung stattfindet. Zudem ergibt sich aufgrund der Spannungsbegrenzungsschaltung und deren Durchbruchspannung, ab dem diese leitet, ein anderer Potentialversatz der HV-Potentiale +, - gegenüber dem Massepotential M. Insbesondere ist dieser Versatz größer als bei dem Umladen oder Entladen, welches bei der aktiven Isolationswiderstandsmessung auftritt und der Versatz stellt sich auch schneller ein (d.h. hat eine höhere Spannungsänderungsrate). Hierbei kann die sich ergebende Spannung, die der Durchbruchsspannung der Spannungsbegrenzungsschaltung entspricht, klar von der Minimalspannung getrennt werden, die sich minimal bei der aktiven Isolationswiderstandsmessung ergibt.

Die Durchbruchsspannung der Spannungsbegrenzungsschaltung ist um eine Mindestmarge kleiner als die minimale Spannung, die bei der aktiven Isolationswiderstandsmessung auftritt. Dadurch können die Fehler getrennt voneinander erfasst werden, insbesondere kann ein Fehler wie dargestellt (Verbindung zwischen HV+ und einer LV-Signalleitung) erfasst werden.

Es kann ein Isolationsmonitor IM vorgesehen sein. Dieser kann mit Spannungsmessern V1, V2 verbunden sein, die die Spannung zwischen dem HV-Potential + und Masse M bzw. HV-Potential - und Masse M erfassen. Mit diesen kann die Isolationsüberwachung IM aktiv den Isolationswiderstand messen. Ferner kann vorgesehen sein, dass diese Spannungsmesser V1, V2 auch zur Ausführung des hier beschriebenen Verfahrens verwendet werden, beispielsweise indem die Potentialänderungsrate oder die sich einstellende Potentialverschiebung gemessen werden. Bevorzugt werden jedoch Spannungsmesser verwendet, die von der Isolationsüberwachungsschaltung IM unabhängig sind, wobei ferner eine Auswerteschaltung mit diesen Spannungsmessern verbunden ist, wobei die Spannungsmesser und die Auswerteschaltung zur Ausführung des hier beschriebenen Verfahrens eingerichtet sind, unabhängig von der aktiven Isolationswiderstandsmessung der Isolationsüberwachungsschaltung IM.

Schließlich ist ein Ladegerät LG dargestellt, welches über eine dreiphasige Leitung mit einem Ladeanschluss LA verbunden ist. An den Ladeanschluss LA kann eine Ladesäule LS angeschlossen werden.

Wird ein Stromfluss verfahrensgemäß erkannt, dann kann vorgesehen sein, dass die Trennschalter TS geöffnet werden, um so den HV-Akkumulator HA abzutrennen. Alternativ oder zusätzlich kann vorgesehen sein, dass die Ladeschaltung LG einen Ladevorgang unterdrückt oder unterbricht. Zudem kann vorgesehen sein, dass eine aktive Isolationswiderstandsmessung durch die Isolationsüberwachungsschaltung IM unterbunden wird, insbesondere das Einprägen eines Teststroms zur Erfassung des Isolationswiderstandes.

Abschließend sei bemerkt, dass die Isolationsüberwachungsschaltung IM den Isolationswiderstand zwischen dem Potential M einerseits und den Potentialen +, - andererseits überwacht, insbesondere indem aktiv ein Teststrom eingeprägt wird und die entsprechende zu erwartende Potentialverschiebung ermittelt wird. Dieser aktive Isolationswiderstandsmessung unterscheidet sich von der Erfassung eines Stromflusses I durch die Spannungsbegrenzungsschaltung SG, da letztere auch bei aufgetrennter Verbindung zwischen den Potentialen G+ und L+ (etwa durchgebrannter Transistor in Niederspannungsgerät NG) einen Isolationsfehler des Hochvoltbordnetzzweigs HB gegenüber dem Niederspannungsbordnetzzweig LB bzw. der Leitung L erkennt.

Der Isolationsfehler RF kann als Zustand betrachtet werden sowie als der Widerstand, der diesen auslöst.

## Patentansprüche

1. Verfahren zum Erfassen eines Isolationsfehlers in einem Fahrzeugbordnetz mit einem HV-Bordnetzzweig (HB) und einem LV-Bordnetzzweig (LB), wobei der LV-Bordnetzzweig (LV) ein positives Versorgungspotential (L+) und ein negatives Versorgungspotential (L-) aufweist, das einem Massepotential (M) des Fahrzeugbordnetzes entspricht und der HV-Bordnetzzweig (HB) ein positives HV-Potential (+) und ein negatives HV-Potential (-) aufweist, die galvanisch von den Potentialen des LV-Bordnetzzweigs (LB) getrennt sind, wobei ein Isolationsfehler (RF) zwischen mindestens einem der HV-Potentiale (-, +) und einem positiven LV-Potential (L+, G+) erfasst wird; das Verfahren **dadurch gekennzeichnet, dass** das Isolationsfehler (RF) durch Erkennen eines Stromflusses (I) durch eine Spannungsbegrenzungsschaltung (SG) erfasst wird, wobei die Spannungsbegrenzungsschaltung (SG) zwischen dem Massepotential (M) und dem positiven LV-Potential (L+, G+) angeschlossen ist, und die eingerichtet ist, oberhalb einer Grenzspannung zu leiten und unterhalb einer Grenzspannung nicht zu leiten.

2. Verfahren nach Anspruch 1, wobei der Stromfluss (I) erkannt wird anhand einer Verschiebung eines der HV-Potentiale (-, +) gegenüber dem Massepotential (M).

3. Verfahren nach Anspruch 2, wobei der Stromfluss (I) erkannt wird anhand einer Potentialveränderungsrate, die über einem vorbestimmten Wert liegt.

4. Verfahren nach Anspruch 2 oder 3, wobei der Stromfluss (I) erkannt wird anhand einer Änderung auf eine Potentialdifferenz zwischen einem der HV-Potential (-, +) und dem Massepotential, die unter einem vorbestimmten Wert liegt, wobei diese Potentialdifferenz auftritt, während die Spannung zwischen den HV-Potentialen (-, +) in einem Normbereich liegt.

5. Verfahren nach einem der Ansprüche 2 - 4, wobei die Verschiebung mittels eines Isolationswächters (IM) erkannt wird.

6. Verfahren nach Anspruch 5, wobei der Isolationswächter ferner einen aktiven Isolationstest des HV-Bordnetzzweigs (HB) ausführt durch aktive Umladen von Cy-Kapazitäten (Cy1, Cy2) zwischen dem Massepotential (M) einerseits und den HV-Potentialen (-, +) andererseits und Erfassen einer durch das Umladen hervorgerufenen Potentialverschiebung, wobei bei Erkennen eines Stromflusses durch die Spannungsbegrenzungsschaltung (SG) das aktive Umladen unterbrochen wird.

7. Verfahren nach Anspruch 6, wobei während des aktiven Umladens eine Potentialdifferenz zwischen einem der HV-Potentiale (-, +) und dem Massepotential nicht unter eine Minimalspannung sinkt und der Stromfluss (I) durch die Spannungsbegrenzungsschaltung (SG) erkannt wird anhand einer Änderung auf eine Potentialdifferenz zwischen dem einen HV-Potential (-, +) und dem Massepotential, die unter einem vorbestimmten Wert liegt, wobei dieser Wert kleiner ist als die Minimalspannung.

8. Verfahren nach Anspruch 5, 6 oder 7, wobei der Stromfluss (I) durch die Spannungsbegrenzungsschaltung (SG) erkannt wird durch Messen mindestens einer Spannung zwischen mindestens einem der HV-Potentiale (HV+, HV-) einerseits und dem Massepotential (M) andererseits mittels mindestens eines Spannungsmessers (V1, V2), der mit dem Isolationswächter (IM) verbunden ist oder mittels mindestens eines Spannungsmessers, der von einer eigenen Auswerteschaltung ausgewertet wird und keine direkte signalübertragende Verbindung mit dem Isolationswächter (IM) aufweist.

9. Verfahren nach einem der vorangehenden Ansprüche, wobei mindestens eine der folgenden Maßnahmen durchgeführt wird, wenn der Isolationsfehler durch Erkennen eines Stromflusses (I) durch die Spannungsbegrenzungsschaltung (SG) erkannt wird:
Abtrennen eines Hochvoltakkumulators (HA) des HV-Bordnetzzweigs (HB) mittels Trennschalter (TS) vom restlichen HV-Bordnetzzweig (HB);
Abtrennen mindestens eines Cy-Filterkondensators des HV-Bordnetzzweigs (HB);
Abtrennen einer an das HV-Bordnetzzweig (HB) angeschlossen Ladesäule;
Entladen des HV-Bordnetzzweigs (HB);
Abtrennen eines HV-Bordnetzunterzweigs von einem Inverter-HV-Bordnetzunterzweig, der einen Traktionsinverter aufweist.

10. Verfahren nach einem der vorangehenden Ansprüche, wobei die Spannungsbegrenzungsschaltung (SG), deren Stromfluss (I) erkannt wird, zwischen dem Massepotential (M) und dem positiven LV-Potential (L+) angeschlossen ist, welches das positive Versorgungspotential des LV-Bordnetzzweigs (LB) ist.

11. Verfahren nach einem der Ansprüche 1 - 9, wobei die Spannungsbegrenzungsschaltung (SG), deren Stromfluss (I) erkannt wird, zwischen dem Massepotential (M) und dem positiven LV-Potential (G+) angeschlossen ist, welches ein positives Leitungspotential des LV-Bordnetzzweigs (LB) ist.

12. Verfahren nach Anspruch 11, wobei ein LV-Gerät (NG) an das Massepotential und an das positive Versorgungspotential (L+) des LV-Bordnetzzweigs (LB), welches das positive Versorgungspotential des LV-Bordnetzzweigs (LB) angeschlossen ist, und wobei an das LV-Gerät Leitungen (L) angeschlossen sind, wobei zumindest eine der Leitungen das positive LV-Potential (G+) aufweist.

13. Verfahren nach Anspruch 12, wobei das LV-Gerät (NG) eine LV-Kommunikationsvorrichtung oder eine LV-Sensorvorrichtung oder ein LV-Steuergerät ist.

14. Verfahren nach einem der vorangehenden Ansprüche, wobei die Spannungsbegrenzungsschaltung (SG), deren Stromfluss (I) gemessen wird, einen Varistor, einen Gasableiter, eine Funkenstrecke, eine Schutzdiode, eine Thyristorschaltung, einen DIAC, einer Zenerdiode und/oder eine Vierschichtdiode umfasst.

## Claims

1. A method for detecting an insulation fault in a vehicle on-board electrical system comprising a high-voltage (HV) on-board electrical system branch (HB) and a low-voltage (LV) on-board electrical system branch (LB), wherein the LV on-board electrical system branch (LV) has a positive supply potential (L+) and a negative supply potential (L-) corresponding to a ground potential (M) of the vehicle on-board electrical system, and the HV on-board electrical system branch (HB) has a positive HV potential (+) and a negative HV potential (-) that are galvanically isolated from the potentials of the LV on-board electrical system branch (LB), wherein an insulation fault (RF) is detected between at least one of the HV potentials (-, +) and a positive LV potential (L+, G+); the method is **characterized in that** the insulation fault (RF) is detected by detecting a current flow (I) through a voltage-limiting circuit (SG), wherein the voltage-limiting circuit (SG) is connected between the ground potential (M) and the positive LV potential (L+, G+), and is configured to conduct above a limit voltage and not to conduct below a limit voltage.

2. The method according to claim 1, wherein the current flow (I) is detected by means of a shift of one of the HV potentials (-, +) relative to the ground potential (M).

3. The method according to claim 2, wherein the current flow (I) is detected based on a potential change rate that is above a predetermined value.

4. The method according to claim 2 or 3, wherein the current flow (I) is detected by means of a change to a potential difference between one of the HV potentials (-, +) and the ground potential, which is below a predetermined value, wherein this potential difference occurs while the voltage between the HV potentials (-, +) is within a normal range.

5. The method according to any one of claims 2-4, wherein the displacement is detected by means of an isolation monitor (IM).

6. The method according to claim 5, wherein the insulation monitor further performs an active insulation test of the HV on-board electrical system branch (HB) by actively recharging Cy capacitances (Cy1, Cy2) between the ground potential (M) on the one hand and the HV potentials (-, +) on the other hand and detecting a potential shift caused by the recharging, wherein the active recharging is interrupted by the voltage-limiting circuit (SG) when a current flow is detected.

7. The method according to claim 6, wherein during active recharging a potential difference between one of the HV potentials (-, +) and the ground potential does not fall below a minimum voltage and the current flow (I) is detected by the voltage-limiting circuit (SG) by means of a change to a potential difference between one of the HV potentials (-, +) and the ground potential that is below a predetermined value, wherein this value is less than the minimum voltage.

8. The method according to claim 5, 6 or 7, wherein the current flow (I) through the voltage-limiting circuit (SG) is detected by measuring at least one voltage between at least one of the HV potentials (HV+, HV-) on the one hand and the ground potential (M) on the other hand by means of at least one voltmeter (V1, V2) which is connected to the insulation monitor (IM) or by means of at least one voltmeter which is evaluated by a separate evaluation circuit and does not have a direct signal-transmitting connection with the insulation monitor (IM).

9. The method according to any one of the preceding claims, wherein at least one of the following measures is carried out when the insulation fault is detected by detecting a current flow (I) through the voltage-limiting circuit (SG):
disconnecting a high-voltage battery (HA) of the HV on-board electrical system branch (HB) from the rest of the HV on-board electrical system branch (HB) by means of a disconnect switch (TS);
disconnecting at least one Cy filter capacitor from the HV on-board electrical system branch (HB);
disconnecting a charging station connected to the HV on-board electrical system (HB);
discharging the HV on-board electrical system branch (HB);
disconnecting an HV on-board electrical system sub-branch from an inverter HV on-board electrical system sub-branch that includes a traction inverter.

10. The method according to any one of the preceding claims, wherein the voltage-limiting circuit (SG), the current flow (I) of which is detected, is connected between the ground potential (M) and the positive LV potential (L+), which is the positive supply potential of the LV on-board electrical system branch (LB).

11. The method according to any one of claims 1-9, wherein the voltage-limiting circuit (SG), the current flow (I) of which is detected, is connected between the ground potential (M) and the positive LV potential (G+), which is a positive line potential of the LV on-board electrical system branch (LB).

12. The method according to claim 11, wherein an LV device (NG) is connected to the ground potential and to the positive supply potential (L+) of the LV on-board electrical system branch (LB), which is connected to the positive supply potential of the LV on-board electrical system branch (LB), and wherein lines (L) are connected to the LV device, wherein at least one of the lines has the positive LV potential (G+).

13. The method according to claim 12, wherein the LV device (NG) is an LV communication device or an LV sensor device or an LV control device.

14. The method according to any one of the preceding claims, wherein the voltage-limiting circuit (SG), the current flow (I) of which is measured, comprises a varistor, a gas discharge tube, a spark gap, a protection diode, a thyristor circuit, a DIAC, a Zener diode and/or a four-layer diode.

## Revendications

1. Procédé pour détecter un défaut d'isolement dans un réseau de bord de véhicule comportant une branche de réseau de bord haute tension HT (HB) et une branche de réseau de bord basse tension BT (LB), la branche de réseau de bord BT (LV) présentant un potentiel d'alimentation positif (L+) et un potentiel d'alimentation négatif (L-) qui correspond à un potentiel de terre (M) du réseau de bord de véhicule et la branche de réseau de bord HT (HB) présentant un potentiel HT positif (+) et un potentiel HT négatif (-) qui sont isolés galvaniquement des potentiels de la branche de réseau de bord BT (LB), un défaut d'isolement (RF) étant détecté entre au moins l'un des potentiels HT (-, +) et un potentiel BT positif (L+, G+) ; le procédé est **caractérisée en ce que** le défaut d'isolement (RF) est détecté en reconnaissant un flux de courant (I) dans un circuit limiteur de tension (SG), le circuit limiteur de tension (SG) étant connecté entre le potentiel de terre (M) et le potentiel BT positif (L+, G+), et étant configuré pour être conducteur au-dessus d'une tension limite et ne pas être conducteur en dessous d'une tension limite.

2. Procédé selon la revendication 1, dans lequel le flux de courant (I) est reconnu au moyen d'un décalage de l'un des potentiels HT (-, +) par rapport au potentiel de terre (M).

3. Procédé selon la revendication 2, dans lequel le flux de courant (I) est reconnu au moyen d'un taux de variation de potentiel qui est supérieur à une valeur prédéterminée.

4. Procédé selon la revendication 2 ou 3, dans lequel le flux de courant (I) est reconnu au moyen d'un changement d'une différence de potentiel entre l'un des potentiels HT (-, +) et le potentiel de terre, qui se situe en dessous d'une valeur prédéterminée, cette différence de potentiel se produisant alors que la tension entre les potentiels HT (-, +) se situe dans une plage normale.

5. Procédé selon l'une des revendications 2 à 4, dans lequel le décalage est reconnu par le biais d'un contrôleur d'isolement (IM).

6. Procédé selon la revendication 5, dans lequel le contrôleur d'isolement effectue en outre un test d'isolement actif de la branche de réseau de bord HT (HB) en rechargeant activement les capacités Cy (Cy1, Cy2) entre le potentiel de terre (M) d'une part et les potentiels HT (-, +) d'autre part et en détectant un décalage de potentiel provoqué par la recharge, la recharge active étant interrompue par le circuit limiteur de tension (SG) lorsqu'un flux de courant est reconnu.

7. Procédé selon la revendication 6, dans lequel, pendant la recharge active, une différence de potentiel entre l'un des potentiels HT (-, +) et le potentiel de terre ne tombe pas en dessous d'une tension minimale et le flux de courant (I) est reconnu par le circuit limiteur de tension (SG) au moyen d'un changement de différence de potentiel entre l'un des potentiels HT (-, +) et le potentiel de terre qui est inférieure à une valeur prédéterminée, cette valeur étant inférieure à la tension minimale.

8. Procédé selon la revendication 5, 6 ou 7, dans lequel le flux de courant (I) à travers le circuit limiteur de tension (SG) est reconnu en mesurant au moins une tension entre au moins l'un des potentiels HT (HV+, HV-) d'une part et le potentiel de terre (M) d'autre part par le biais d'au moins un voltmètre (V1, V2) qui est connecté au contrôleur d'isolement (IM) ou par le biais d'au moins un voltmètre qui est évalué par un circuit d'évaluation propre et ne présente pas de connexion directe de transmission de signaux avec le contrôleur d'isolement (IM).

9. Procédé selon l'une quelconque des revendications précédentes, dans lequel au moins une des mesures suivantes est mise en œuvre lorsque le défaut d'isolement est reconnu par reconnaissance d'un flux de courant (I) dans le circuit limiteur de tension (SG) :
déconnexion d'une batterie haute tension (HA) de la branche de réseau de bord HT (HB) du reste de la branche de réseau de bord HT (HB) par le biais d'un interrupteur de déconnexion (TS) ;
déconnexion d'au moins un condensateur de filtrage Cy de la branche de réseau de bord HT (HB) ;
déconnexion d'une station de recharge connectée à la branche de réseau de bord HT (HB) ; déchargement de la branche de réseau de bord HT (HB) ;
déconnexion d'une sous-branche de réseau de bord HT d'une sous-branche de réseau de bord HT-onduleur présentant un onduleur de traction.

10. Procédé selon l'une quelconque des revendications précédentes, dans lequel le circuit limiteur de tension (SG), dont le flux de courant (I) est reconnu, est connecté entre le potentiel de terre (M) et le potentiel BT positif (L+), qui est le potentiel d'alimentation positif de la branche de réseau de bord BT (LB).

11. Procédé selon l'une des revendications 1 à 9, dans lequel le circuit limiteur de tension (SG), dont le flux de courant (I) est reconnu, est connecté entre le potentiel de terre (M) et le potentiel BT positif (G+), qui est un potentiel de ligne positif de la branche de réseau de bord BT (LB).

12. Procédé selon la revendication 11, dans lequel un appareil BT (NG) est connecté au potentiel de terre et au potentiel d'alimentation positif (L+) de la branche de réseau de bord BT (LB), qui est connectée au potentiel d'alimentation positif de la branche de réseau de bord BT (LB), et dans lequel des lignes (L) sont connectées à l'appareil BT, au moins une des lignes présentant le potentiel BT positif (G+).

13. Procédé selon la revendication 12, dans lequel l'appareil BT (NG) est un dispositif de communication BT, un dispositif de capteur BT ou un appareil de commande BT.

14. Procédé selon l'une quelconque des revendications précédentes, dans lequel le circuit limiteur de tension (SG), dont le flux de courant (I) est mesuré, comprend une varistance, un tube à décharge gazeuse, un éclateur, une diode de protection, un circuit thyristor, un DIAC, une diode Zener et/ou une diode à quatre couches.
